# FASCICULE DE BREVET EUROPEEN

(11) **EP 2 254 243 B1**
(45) Date de publication et mention de la délivrance du brevet: **05.10.2011**
(21) Numéro de dépôt: 10158033.0
(22) Date de dépôt: 26.03.2010
(51) Int. Cl.: H03H 3/04, H03H 9/17

(54) **Résonateur à ondes acoustiques de volume et son procédé de fabrication**
Akustischer Volumenwellenresonator und Herstellungsverfahren dafür
Bulk Acoustic Resonator and method for manufacturing same

(30) Priorité: 20.05.2009 FR 0953373
(43) Date de publication de la demande: 24.11.2010
(73) Titulaire: STmicroelectronics SA, 92120 Montrouge (FR)
(72) Inventeur: Coudrain, Perceval, 38000, Grenoble (FR); Petit, David, 38600 Fontaine (FR)
(74) Mandataire: de Beaumont, Michel

(56) Documents cités:
- EP-A2- 1 291 317
- US-A1- 2004 012 463

## Description

### Domaine de l'invention

La présente invention concerne un résonateur piézoélectrique à ondes acoustiques de volume et son procédé de fabrication.

### Exposé de l'art antérieur

Les résonateurs piézoélectriques à ondes acoustiques de volume (BAW, en anglais Bulk Acoustic Wave) sont généralement utilisés pour former des filtres ou des éléments résonants. Ils peuvent notamment être utilisés dans des dispositifs assurant des fonctions de référence de temps ou de fréquence (par exemple des oscillateurs compensés en température, TCXO, en anglais Temperature Compensated X-Tal Oscillator).

Un résonateur BAW est constitué d'une couche de matériau piézoélectrique prise en sandwich entre deux électrodes métalliques. Les électrodes sont généralement en molybdène, en tungstène, en aluminium ou en platine. Lorsque l'on applique une excitation électrique entre les deux électrodes, la couche piézoélectrique se dilate ou se contracte dans le sens de son épaisseur. On génère ainsi des vibrations mécaniques dans la couche piézoélectrique, ces vibrations créant elles-mêmes un signal électrique. La résonance fondamentale du système est observée lorsque les vibrations mécaniques et le champ électrique induit génèrent une onde constructive, optimisant ainsi l'énergie de transfert entre les deux vibrations.

Afin d'obtenir des résonateurs BAW présentant des coefficients de qualité (Q) et de couplage électromagnétique (Kt²) importants, on prévoit généralement d'isoler ces résonateurs du substrat sur lesquels ils sont formés. Cette isolation permet le confinement de l'énergie acoustique dans le résonateur. Pour réaliser cette isolation, deux structures sont connues : le résonateur peut être suspendu au-dessus d'un évidement ou il peut être formé sur un miroir acoustique (aussi appelé miroir de Bragg). Un inconvénient d'un miroir de Bragg est la multiplicité des opérations nécessaires à sa fabrication.

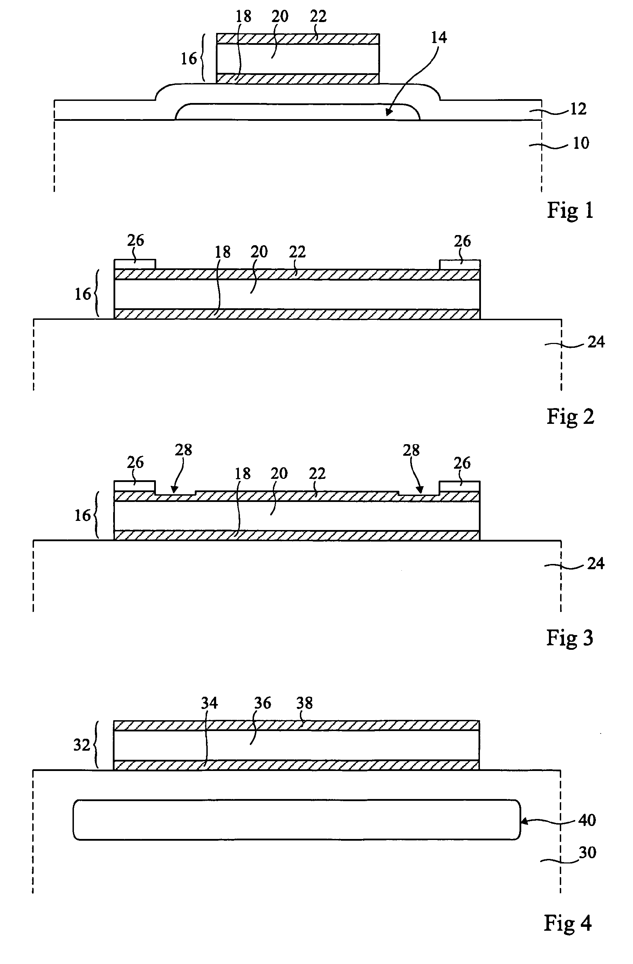

La figure 1 illustre un exemple d'un résonateur suspendu au-dessus d'un évidement. Ce type de résonateur, formé sur un film mince, est couramment appelé dispositif FBAR, TFBAR ou TFR (en anglais Thin Film Bulk Acoustic Resonator).

Sur un substrat de silicium 10 est formée une membrane 12, par exemple en nitrure de silicium. La membrane 12 est éloignée du substrat 10 en son centre par un évidement 14, tandis que sa périphérie est en contact avec le substrat 10. Sur la partie de la membrane 12 éloignée du substrat (au-dessus de l'évidement 14), est formé un empilement 16 formant le dispositif résonant. L'empilement 16 comprend une première couche conductrice 18 formant la première électrode métallique du résonateur, une région de matériau piézoélectrique 20 et une seconde couche conductrice 22 formant la seconde électrode du résonateur. On notera que, dans cette figure et dans celles qui suivent, les reprises de contact sur les première et seconde électrodes 18 et 22 ne sont pas représentées.

Un inconvénient d'une structure telle que celle représentée en figure 1 réside dans la complexité de son procédé de fabrication. En effet, pour former la membrane suspendue 12, on forme une couche sacrificielle sous cette membrane, puis on élimine cette couche. D'autres variantes connues permettent de former une cavité sous l'empilement résonant. L'une d'entre elles consiste à former une ouverture en surface du substrat, puis l'empilement résonant est formé sur une couche intermédiaire plane s'étendant sur le substrat. Ce procédé a l'inconvénient de nécessiter la formation de la couche intermédiaire sur le substrat. Une autre variante consiste à former le résonateur directement sur le substrat et à graver une partie de celui-ci à partir de sa face opposée au résonateur. Cependant, cette solution n'est possible que dans le cas d'un substrat relativement fin et ne peut être adaptée à des substrats massifs.

De plus, un inconvénient lié aux dispositifs résonants de dimensions finies tels que celui de la figure 1 est qu'il se forme, dans le résonateur, des modes acoustiques parasites dégradant le facteur de qualité. Pour caractériser un dispositif résonant, il est connu d'en tracer la "courbe de dispersion", qui illustre ces modes acoustiques parasites. On distingue deux types de courbes, des courbes de dispersion de "type I" dans le cas où la fréquence de résonance du second harmonique du mode transverse est inférieure à la fréquence de résonance du mode longitudinal, et des courbes de dispersion de "type II" dans le cas où la fréquence de résonance du second harmonique du mode transverse est supérieure à la fréquence de résonance du mode longitudinal.

En fonction du matériau piézoélectrique utilisé ou de l'empilement du résonateur, les courbes de dispersion peuvent être de type I ou de type II. Pour empêcher la formation des modes acoustiques parasites, il est connu de former, en périphérie de la surface externe du dispositif résonant, un cadre rigide (en anglais "frame"). Cette technique est présentée, dans le cas de courbes de dispersion de type I et II, dans la publication intitulée "Spurious mode suppression in BAW resonators", de Robert Thalhammer et al., IEEE 2006, 1054-0117/06.

La figure 2 illustre un premier exemple d'un tel dispositif résonant, dans le cas où le matériau piézoélectrique, ou l'élément résonant dans sa globalité, présente une courbe de dispersion de type I. Un tel matériau piézoélectrique est par exemple l'oxyde de zinc.

Le résonateur comprend un empilement 16 (première couche conductrice 18, couche piézoélectrique 20 et deuxième couche conductrice 22) formé sur un support 24, par exemple un miroir de Bragg ou une membrane suspendue. Pour éviter la génération des modes acoustiques parasites en périphérie de l'empilement 16, un cadre 26, par exemple en oxyde de silicium, est formé, en surface de l'empilement 16, sur toute la périphérie de celui-ci. Le cadre 26 assure l'adaptation entre la zone active du résonateur et l'extérieur de celui-ci.

La figure 3 illustre un deuxième exemple d'un dispositif résonant dans le cas où le matériau piézoélectrique, ou l'élément résonant dans sa globalité, présente une courbe de dispersion de type II. Un tel matériau piézoélectrique est par exemple le nitrure d'aluminium.

Le résonateur comprend un empilement 16 similaire à celui de la figure 2 (première couche conductrice 18, couche piézoélectrique 20 et seconde couche conductrice 22), formé sur un support 24, par exemple un miroir de Bragg ou une membrane suspendue. En périphérie de la surface de l'empilement 16 est formé un cadre 26, par exemple en oxyde de silicium, permettant d'atténuer les modes acoustiques parasites en périphérie de l'empilement 16. Dans ce dispositif, l'épaisseur de la seconde couche conductrice 22 est réduite dans une région 28 formant, en vue de dessus, un cadre situé au contact interne du cadre périphérique 26.

Un inconvénient des dispositifs tels que présentés en figures 2 et 3 est que leurs surfaces supérieures sont fortement marquées (topologie), du fait de la présence du cadre 26 en surface de l'empilement 16. De plus, la formation du cadre 26 nécessite au moins une étape de dépôt et une étape de gravure, en plus des étapes de formation de l'empilement résonnant.

La figure 4 illustre un autre exemple d'un dispositif résonant selon l'art antérieur. Un tel dispositif résonant est décrit par le document US 2004/012463.

Sur un substrat de silicium 30 est formé un empilement résonant 32 comprenant une première couche conductrice 34 formant une première électrode, une région de matériau piézoélectrique 36 et une seconde couche conductrice 38 formant une seconde électrode. Dans le substrat de silicium 30, en profondeur sous l'empilement 32, est formée une cavité enterrée 40. La cavité enterrée 40 s'étend au moins en regard de l'empilement 32. Elle peut également s'étendre sur une surface légèrement plus importante que la surface occupée par l'empilement 32. On notera que, dans cette figure et dans celles qui suivent, les reprises de contact sur les première et seconde électrodes 34 et 38 ne sont pas représentées.

La cavité 40 présente une réflexion acoustique parfaite. Ainsi, toutes les ondes acoustiques sont réfléchies au niveau de l'interface entre le substrat 30 et la cavité 40. On obtient donc avantageusement une réflexion des ondes acoustiques d'aussi bonne qualité que dans les dispositifs de type FBAR, et ce quelle que soit la fréquence des ondes acoustiques considérées. Pour former la cavité 40, on prévoit de tirer profit des procédés de formation d'espace vide dans du silicium (en anglais ESS, Empty Space in Silicon), comme cela sera décrit plus en détail par la suite.

### Résumé

Un objet d'un mode de réalisation de la présente invention est de prévoir un dispositif résonant palliant les inconvénients des dispositifs résonants connus.

Un autre objet d'un mode de réalisation de la présente invention est de prévoir un dispositif présentant un facteur de qualité important sur une bande de fréquences importante.

Un autre objet d'un mode de réalisation de la présente invention est de prévoir un procédé simple de fabrication d'un tel dispositif résonant.

Ainsi, un mode de réalisation de la présente invention prévoit un dispositif résonant comprenant un empilement d'une première couche métallique, d'une couche de matériau piézoélectrique et d'une seconde couche métallique formé sur un substrat de silicium, une cavité étant formée en profondeur dans le substrat, l'épaisseur du silicium au-dessus de la cavité ayant au moins une première valeur dans une première région située en regard du centre de l'empilement, une deuxième valeur dans une deuxième région située sous la périphérie de l'empilement et au moins une troisième valeur dans une troisième région entourant la deuxième région, la deuxième valeur étant supérieure aux première et troisième valeurs.

Selon un mode de réalisation de la présente invention, l'élément résonant présente une courbe de dispersion de type I.

Selon un mode de réalisation de la présente invention, le matériau piézoélectrique est de l'oxyde de zinc.

Selon un mode de réalisation de la présente invention, l'épaisseur de silicium au-dessus de la cavité a une quatrième valeur dans une quatrième région située entre les première et deuxième régions, la quatrième valeur étant inférieure à la première valeur.

Selon un mode de réalisation de la présente invention, l'élément résonant présente une courbe de dispersion de type II.

Selon un mode de réalisation de la présente invention, le matériau piézoélectrique est du nitrure d'aluminium.

Selon un mode de réalisation de la présente invention, l'empilement comprend en outre une couche de compensation dont le coefficient de température est opposé à celui du matériau piézoélectrique.

Un mode de réalisation de la présente invention prévoit en outre un procédé de formation d'un dispositif résonant, comprenant les étapes suivantes :
former, dans un substrat de silicium, un premier ensemble régulier d'ouvertures dans une première région du substrat, un deuxième ensemble régulier d'ouvertures dans une deuxième région du substrat entourant la première région et un troisième ensemble régulier d'ouvertures dans une troisième région du substrat entourant la deuxième région, le rapport entre la section des ouvertures et le pas des ouvertures du deuxième ensemble étant inférieur au même rapport des premier et troisième ensembles ;
réaliser un recuit de la structure d'où il résulte qu'il se forme une cavité enterrée dans le substrat dont la surface supérieure est à des profondeurs différentes ; et
former, sur le substrat, en regard de la partie de la cavité associée aux premier et deuxième ensembles d'ouvertures, un empilement d'une première couche métallique, d'une couche de matériau piézoélectrique et d'une seconde couche métallique.

Selon un mode de réalisation de la présente invention, un quatrième ensemble régulier d'ouvertures est formé dans le substrat, entre les premier et deuxième ensembles d'ouvertures, le rapport entre la section des ouvertures et le pas des ouvertures du quatrième ensemble étant supérieur à celui du premier ensemble.

Selon un mode de réalisation de la présente invention, le recuit de la structure est réalisé sous hydrogène et à une température supérieure à 1100°C.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, illustre un exemple d'un dispositif résonant formé sur une membrane suspendue ;
la figure 2, précédemment décrite, illustre une structure connue permettant d'atténuer des modes parasites dans un résonateur ;
la figure 3, précédemment décrite, illustre une autre structure connue permettant d'atténuer des modes parasites dans un autre résonateur ;
la figure 4 illustre un premier mode de réalisation d'un dispositif résonant ;
la figure 5 illustre un deuxième mode de réalisation d'un dispositif résonant ;
la figure 6 illustre un troisième mode de réalisation d'un dispositif résonant ; et
les figures 7A à 7D illustrent des étapes de fabrication du dispositif résonant de la figure 5.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

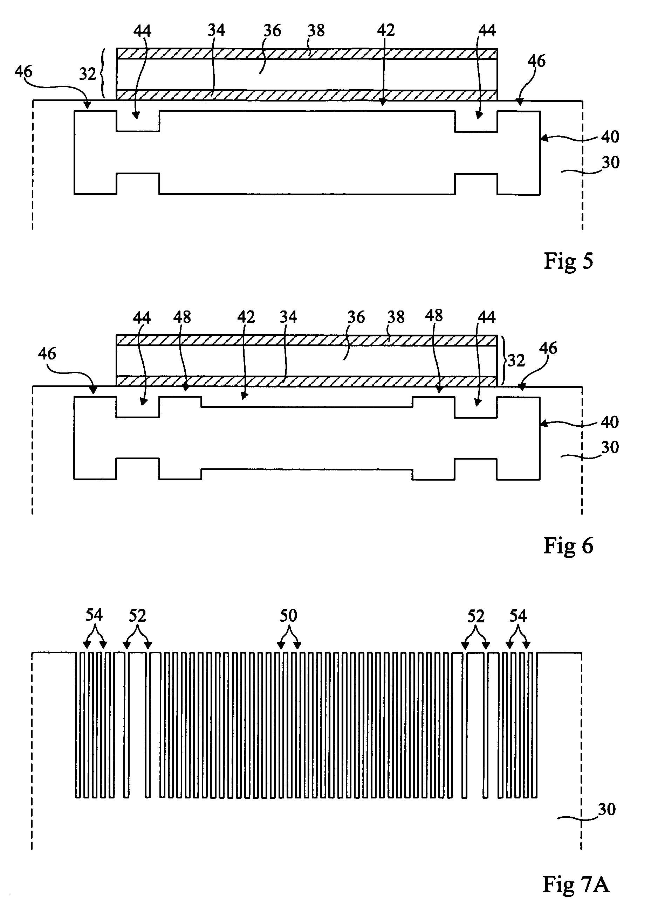

La figure 5 illustre un mode de réalisation d'un dispositif résonant dans le cas d'un résonateur présentant une courbe de dispersion de type I.

Le dispositif résonant comprend des éléments similaires au dispositif de la figure 4, à savoir un empilement 32, formé sur un substrat de silicium 30, comprenant une première couche conductrice 34, une couche de matériau piézoélectrique 36 et une seconde couche conductrice 38. La différence avec le dispositif de la figure 4 réside dans la forme de la cavité enterrée 40 formée dans le substrat 30. Dans ce mode de réalisation, la cavité 40 s'étend sur une surface légèrement plus grande que la surface occupée par l'empilement 32.

La cavité 40 est prévue de façon que le silicium situé au-dessus de celle-ci présente différentes épaisseurs. Il comprend une première région 42, située en regard du centre de l'empilement résonant 32, une deuxième région 44 située, sous l'empilement 32, en regard de sa périphérie, et une troisième région 46 située en regard du contour externe de l'empilement 32. L'épaisseur de la région 42 est inférieure à l'épaisseur de la région 44, et l'épaisseur de la région 46 est inférieure à l'épaisseur de la région 44.

Les inventeurs ont montré qu'une structure telle que celle de la figure 5, dans laquelle le silicium entre l'empilement résonant 32 et la cavité 40 présente des épaisseurs différentes, permet une adaptation des modes acoustiques parasites dans le résonateur similaire à celle procurée par un cadre formé en surface du résonateur, comme dans le dispositif de la figure 2. De plus, l'intégration des éléments assurant l'adaptation des modes acoustiques parasites directement dans la cavité permet de réduire la complexité de la surface supérieure du dispositif (topologie).

Dans l'exemple représenté, les régions 42 et 46 ont des épaisseurs identiques. On notera que ceci n'est qu'un exemple de réalisation. De plus, la cavité 40 est représentée comme étant symétrique par rapport à un plan central parallèle à la surface supérieure du substrat 30. On notera que seule la limite supérieure de la cavité importe pour le fonctionnement du dispositif, et que la limite inférieure de la cavité pourra être de toute autre forme.

La figure 6 illustre un mode de réalisation d'un dispositif résonant dans le cas d'un résonateur présentant une courbe de dispersion de type II.

Le substrat situé au-dessus la cavité 40 comprend quatre régions. Les trois premières 42, 44 et 46 sont, respectivement, similaires aux régions de mêmes références de la figure 5, et sont situées, respectivement, en regard d'une partie centrale de l'empilement 32, en regard de la périphérie de l'empilement, et en regard d'un contour externe de l'empilement. Une quatrième région 48 du substrat est formée, en regard de l'empilement 32, entre les première et deuxième régions, l'épaisseur de la quatrième région 48 ayant une valeur plus faible que l'épaisseur de la première région.

De la même façon que dans le cas de la figure 5, les inventeurs ont montré qu'une structure telle que celle de la figure 6 procure des avantages identiques à la structure de la figure 3, en ce qui concerne l'atténuation des modes parasites.

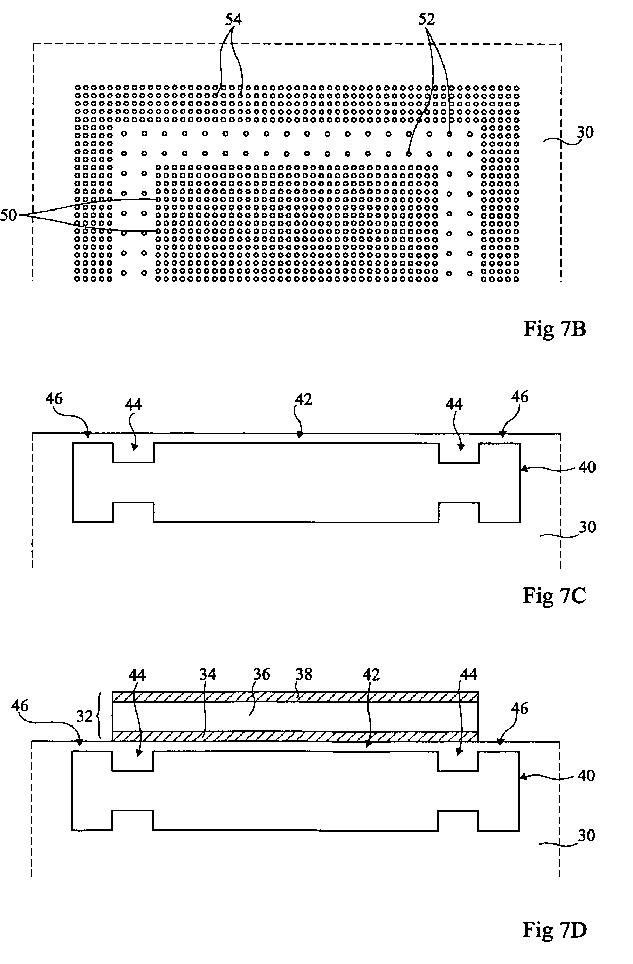

Les figures 7A à 7D illustrent des étapes de fabrication du dispositif résonant de la figure 5, la figure 7B étant une vue de dessus partielle du dispositif représenté en coupe en figure 7A.

Comme l'illustre les figures 7A et 7B, on part d'un substrat de silicium 30 dans lequel sont formés plusieurs ensembles réguliers d'ouvertures non traversantes 50, 52 et 54. Comme cela est visible en figure 7B, l'ensemble d'ouvertures 50 est formé dans une région centrale du substrat 30, l'ensemble d'ouvertures 52 est formé autour de l'ensemble d'ouvertures 50 et l'ensemble d'ouvertures 54 est formé autour de l'ensemble d'ouvertures 52. On notera que, contrairement à ce qui est représenté dans les figures, l'ensemble d'ouvertures 50 occupe de préférence la plus grande proportion de l'espace occupé par les différents ensembles d'ouvertures.

Dans chaque ensemble d'ouvertures, les ouvertures 50, 52 et 54 sont régulièrement réparties en surface du substrat de silicium 30. Dans l'exemple représenté, les ouvertures 50, 52 et 54 ont des diamètres identiques mais le pas entre les ouvertures des différents ensembles varie, le pas entre les ouvertures 52 étant plus important que le pas entre les ouvertures 50 et 54. De plus, à titre d'exemple, les pas entre les ouvertures 50 et 54 sont représentés égaux.

A l'étape illustrée en figure 7C, on a réalisé un recuit de la structure des figures 7A et 7B. Ce recuit est réalisé à une température supérieure à 1100°C, sous un flux d'hydrogène, par exemple pendant une durée de quelques centaines de secondes. Il permet d'obtenir, dans le substrat de silicium 30, une cavité enterrée 40 dont la surface supérieure est à des niveaux différents dans le substrat 30. Cette différence de niveaux est liée à la différence de pas entre les ouvertures 50, 52 et 54.

Pour que les ouvertures 50, 52 et 54 se referment en profondeur dans le substrat et forment la cavité 40, le rapport entre le pas des ouvertures et le diamètre des ouvertures est choisi inférieur à un certain seuil qui sera aisément déterminé par l'homme de l'art pour du silicium d'orientation et de dopage donnés. Ainsi, en jouant sur la profondeur, la section et/ou le pas des ouvertures, on obtient une cavité 40 dont la limite supérieure est à des profondeurs désirées dans le substrat 30.

Dans l'exemple représenté, le pas des ouvertures 50 et 54 est plus faible que le pas des ouvertures 52 pour des sections égales. Ceci permet de former une cavité 40 dans laquelle l'épaisseur de substrat au-dessus de la cavité 40 est faible dans une région centrale 42 (au niveau de l'ensemble d'ouvertures 50) et dans une région périphérique 46 du dispositif (au niveau de l'ensemble d'ouvertures 54), et plus élevée dans une région intermédiaire 44 du dispositif, entre les régions centrale et périphérique (au niveau de l'ensemble d'ouvertures 52).

De façon générale, pour que les régions 42 et 46 soient moins épaisses que la région 44, le rapport entre la section des ouvertures et le pas entre les ouvertures du deuxième ensemble doit être inférieur au même rapport pour les ouvertures des premier et troisième ensembles.

A titre d'exemple de valeurs numériques, dans le cas où le pas entre les ouvertures 50, 52 et 54 est le même (par exemple de 0,7 µm) et où la section des ouvertures 50, 52 et 54 varie, on peut choisir les valeurs suivantes :
diamètre des ouvertures 50 et 54 = 0,5 µm ;
profondeur des ouvertures 50 et 54 = 3 µm ;
diamètre des ouvertures 52 = 0,35 µm ; et
profondeur des ouvertures 52 = 3 µm.

Avec ces valeurs, on obtient une cavité 40 dont la limite inférieure est quasi plane, des régions 42 et 46 ayant une épaisseur de l'ordre de 0,8 µm et une région 44 ayant une épaisseur de l'ordre de 1,2 µm. Ces valeurs sont particulièrement adaptées à la formation du dispositif de la figure 5.

On notera qu'en faisant varier le pas, la section et la profondeur des ouvertures 50, 52 et 54, on peut obtenir une cavité 40 de toute forme désirée, permettant différentes adaptations des dispositifs résonants.

A l'étape illustrée en figure 7D, on a formé un empilement résonant 32 sur la structure de la figure 7C au-dessus des régions de silicium 42 et 44. L'empilement comprend une première couche métallique 34, une couche de matériau piézoélectrique 36 et une seconde couche métallique 38. L'empilement 32 peut être formé par tout procédé connu, par exemple en déposant des couches de matériaux conducteurs et piézoélectrique sur tout le substrat puis en gravant ces couches de façon adaptée. Ainsi, on obtient le dispositif de la figure 5. Le procédé présenté ici permet, avantageusement, la formation en une étape de la cavité 40 et des éléments permettant l'atténuation des modes parasites. Le nombre d'étapes à réaliser est ainsi relativement faible. On notera que l'on pourra prévoir une étape de polissage de la surface du substrat 30, après la formation de la cavité 40 (étape de la figure 7C), pour assurer la planéité de la surface supérieure du substrat.

De la même façon, pour obtenir le dispositif de la figure 6, on prévoira la formation d'un ensemble d'ouvertures supplémentaires dans le substrat 30, à l'étape de la figure 7A, entre les premier et deuxième ensembles d'ouvertures 50 et 52. Le rapport entre la section et le pas des ouvertures de l'ensemble d'ouvertures supplémentaires sera choisi de façon que la cavité formée à l'étape de la figure 7C ait une limite supérieure moins profonde que la limite supérieure de la région 42, à savoir supérieur à ce même rapport pour les ouvertures 50.

Ainsi, avantageusement, le procédé présenté ici permet, en une seule étape de recuit, la formation d'une cavité 40, sous un résonateur à ondes acoustiques de volume, présentant une forme particulière permettant l'atténuation des modes parasites et donc l'obtention de résonateurs présentant des facteurs de qualité importants sur une bande de fréquences importante.

On notera que les fréquences caractéristiques d'un résonateur à ondes acoustiques de volume peuvent varier en fonction de la température. Pour éviter cette dérive en fréquence, on pourra prévoir la formation, dans l'empilement résonant, d'une couche de compensation. Cette couche de compensation sera prévue avec un coefficient de température opposé à celui du matériau piézoélectrique, pour s'opposer à la dérive de fréquence du résonateur. On notera qu'une électrode, ou les deux électrodes, peuvent elles-mêmes être prévues pour réaliser cette compensation.

Des modes de réalisation particuliers de la présente invention ont été décrits. Diverses variantes et modifications apparaîtront à l'homme de l'art. En particulier, les ouvertures 50, 52 et 54 ont été représentées comme ayant des sections circulaires. A titre de variante, ces ouvertures pourront avoir toute section désirée. De plus, généralement, plusieurs dispositifs résonants sont formés en parallèle sur un même substrat. Dans ce cas, on pourra prévoir de former une unique cavité enterrée dans le substrat pour plusieurs éléments résonants, la paroi supérieure de la cavité étant à des profondeurs adaptées en conséquence.

## Revendications

1. Dispositif résonant comprenant un empilement (32) d'une première couche métallique (34), d'une couche de matériau piézoélectrique (36) et d'une seconde couche métallique (38) formé sur un substrat de silicium (30), une cavité (40) étant formée en profondeur dans le substrat, l'épaisseur du silicium au-dessus de la cavité ayant au moins une première valeur dans une première région (42) située en regard du centre de l'empilement (32), une deuxième valeur dans une deuxième région (44) située sous la périphérie de l'empilement et au moins une troisième valeur dans une troisième région (46) entourant la deuxième région, la deuxième valeur étant supérieure aux première et troisième valeurs.

2. Dispositif résonant selon la revendication 1, dans lequel l'élément résonant présente une courbe de dispersion de type I.

3. Dispositif résonant selon la revendication 1 ou 2, dans lequel le matériau piézoélectrique (36) est de l'oxyde de zinc.

4. Dispositif résonant selon la revendication 1, dans lequel l'épaisseur de silicium (30) au-dessus de la cavité (40) a une quatrième valeur dans une quatrième région (48) située entre les première et deuxième régions (42, 44), la quatrième valeur étant inférieure à la première valeur.

5. Dispositif selon la revendication 4, dans lequel l'élément résonant présente une courbe de dispersion de type II.

6. Dispositif selon la revendication 4 ou 5, dans lequel le matériau piézoélectrique est du nitrure d'aluminium.

7. Dispositif selon l'une quelconque des revendications 1 à 6, dans lequel l'empilement comprend en outre une couche de compensation dont le coefficient de température est opposé à celui du matériau piézoélectrique.

8. Procédé de formation d'un dispositif résonant, comprenant les étapes suivantes :
former, dans un substrat de silicium (30), un premier ensemble régulier d'ouvertures (50) dans une première région du substrat, un deuxième ensemble régulier d'ouvertures (52) dans une deuxième région du substrat entourant la première région et un troisième ensemble régulier d'ouvertures (54) dans une troisième région du substrat entourant la deuxième région, le rapport entre la section des ouvertures et le pas des ouvertures du deuxième ensemble étant inférieur au même rapport des premier et troisième ensembles ;
réaliser un recuit de la structure d'où il résulte qu'il se forme une cavité enterrée (40) dans le substrat dont la surface supérieure est à des profondeurs différentes ; et
former, sur le substrat, en regard de la partie de la cavité associée aux premier et deuxième ensembles d'ouvertures, un empilement (32) d'une première couche métallique (34), d'une couche de matériau piézoélectrique (36) et d'une seconde couche métallique (38).

9. Procédé selon la revendication 8, dans lequel un quatrième ensemble régulier d'ouvertures est formé dans le substrat (30), entre les premier et deuxième ensembles d'ouvertures (50, 52), le rapport entre la section des ouvertures et le pas des ouvertures du quatrième ensemble étant supérieur à celui du premier ensemble.

10. Procédé selon la revendication 8 ou 9, dans lequel le recuit de la structure est réalisé sous hydrogène et à une température supérieure à 1100°C.

## Claims

1. A resonant device comprising a stack (32) of a first metal layer (34), a piezoelectric material layer (36), and a second metal layer (38) formed on a silicon substrate (30), a cavity (40) being formed in depth in the substrate, the thickness of the silicon above the cavity having at least a first value in a first region (42) located opposite to the center of the stack (32), having a second value in a second region (44) located under the periphery of the stack and having at least a third value in a third region (46) surrounding the second region, the second value being greater than the first and the third values.

2. The resonant device of claim 1, wherein the resonant element has a type-I dispersion curve.

3. The resonant device of claim 1 or 2, wherein the piezoelectric material (36) is zinc oxide.

4. The resonant device of claim 1, wherein the silicon thickness (30) above the cavity (40) has a fourth value in a fourth region (48) located between the first and second regions (42, 44), the fourth value being smaller than the first value.

5. The device of claim 4, wherein the resonant element has a type-II dispersion curve.

6. The device of claim 4 or 5, wherein the piezoelectric material is aluminum nitride.

7. The device of any of claims 1 to 6, wherein the stack further comprises a compensation layer having a temperature coefficient opposite to that of the piezoelectric material.

8. A method for forming a resonant device, comprising the steps of:
forming, in a silicon substrate (30), a first regular set of openings (50) in a first region of the substrate, a second regular set of openings (52) in a second region of the substrate surrounding the first region, and a third regular set of openings (54) in a third region of the substrate surrounding the second region, the ratio between the cross-section of the openings and the step between the openings of the second set being smaller than the same ratio of the first and third sets;
annealing the structure, whereby a buried cavity (40) forms in the substrate, with an upper surface at different depths; and
forming, on the substrate, opposite to the cavity portion associated with the first and second sets of openings, a stack (32) of a first metal layer (34), of a piezoelectric material layer (36), and of a second metal layer (38).

9. The method of claim 8, wherein a fourth regular set of openings is formed in the substrate (30), between the first and second sets of openings (50, 52), the ratio between the cross-section of the openings and the step between the openings of the fourth set being greater than that of the first set.

10. The method of claim 8 or 9, wherein the structure is annealed under hydrogen at a temperature greater than 1,100°C.

## Patentansprüche

1. Resonanzeinrichtung mit einem Stapel (32) aus einer ersten Metallschicht (34), einer Schicht aus piezoelektrischen Material (36) und einer zweiten Metallschicht (38), die auf einem Siliziumsubstrat (30) ausgebildet sind, einem Hohlraum (40), der in der Tiefe des Substrats ausgebildet ist, wobei die Dicke des Siliziums über dem Hohlraum in einem ersten Bereich (42), der den Zentrum des Stapels (32) gegenüberliegt, wenigstens einen ersten Wert hat, in einem zweiten Bereich (44), der unter dem Umfang des Stapels liegt, einen zweiten Wert hat, und in einem dritten Bereich (46), welcher den zweiten Bereich umgibt, wenigstens einen dritten Wert hat, wobei der zweite Wert größer ist als der erste Wert und der dritte Wert.

2. Resonanzeinrichtung nach Anspruch 1, wobei das Resonanzelement eine Dispersionskurve des I-Typs aufweist.

3. Resonanzeinrichtung nach Anspruch 1 oder 2, wobei das piezoelektrische Material (36) Zinkoxid ist.

4. Resonanzeinrichtung nach Anspruch 1, wobei die Dicke des Siliziums (30) über dem Hohlraum (40) in einem vierten Bereich (48), der zwischen dem ersten und dem zweiten Bereich (42, 44) liegt, einen vierten Wert hat, wobei der vierte Wert kleiner ist als der erste Wert.

5. Einrichtung nach Anspruch 4, wobei das Resonanzelement eine Dispersionskurve des II-Typs aufweist.

6. Einrichtung nach Anspruch 4 oder 5, wobei das piezoelektrische Material Aluminiumnitrid ist.

7. Einrichtung nach einem der Ansprüche 1 bis 6, wobei der Stapel ferner eine Kompensationsschicht aufweist, deren Temperaturkoeffizient dem des piezoelektrischen Materials entgegengesetzt ist.

8. Verfahren zum Ausbilden einer Resonanzeinrichtung mit den Verfahrensschritten:
Ausbilden, in einem Siliziumsubstrat (30), einer ersten regelmäßigen Anordnung von Öffnungen (50) in einem ersten Bereich des Substrats, einer zweiten regelmäßigen Anordnung von Öffnungen (52) in einem zweiten Bereich des Substrats, welcher den ersten Bereich umgibt, und einer dritten regelmäßigen Anordnung von Öffnungen (54) in einem dritten Bereich des Substrats, welcher den zweiten Bereich umgibt, wobei das Verhältnis zwischen den Querschnitten der Öffnungen und der Schrittweite der Öffnungen der zweiten Anordnung kleiner ist als dasselbe Verhältnis der ersten und der dritten Anordnung;
Glühen der Struktur, wodurch sich ein verdeckter Hohlraum (40) in dem Substrat ausbildet, dessen Oberseite bei unterschiedlichen Tiefen liegt; und
Ausbilden eines Stapels (32) aus einer ersten Metallschicht (34), einer Schicht aus einem piezoelektrischen Material (36) und einer zweiten Metallschicht (38) auf dem Substrat und dem Teil des Hohlraums, welcher der ersten und der zweiten Anordnung von Öffnungen zugeordnet ist, gegenüberliegend.

9. Verfahren nach Anspruch 8, wobei eine vierte regelmäßige Anordnung von Öffnungen in dem Substrat (30) zwischen der ersten und der zweiten Anordnung von Öffnungen (50, 52) ausgebildet wird, wobei das Verhältnis zwischen dem Querschnitt der Öffnungen und der Schrittweite zwischen den Öffnungen der vierten Anordnung gröβer ist als das der ersten Anordnung.

10. Verfahren nach Anspruch 8 oder 9, wobei das Glühen der Struktur in Wasserstoff und bei einer Temperatur von mehr als 1.100 °C ausgeführt wird.
